Europäisches Patentamt

European Patent Office

Office européen des brevets

(11) Publication number: **0 028 514**
**B1**

(12) **EUROPEAN PATENT SPECIFICATION**

(45) Date of publication of patent specification: **16.05.84**   (51) Int. Cl.³: **C 23 C 13/04**

(21) Application number: **80303880.1**

(22) Date of filing: **30.10.80**

(54) Process of vapor depositing photoconductive material.

(30) Priority: **01.11.79 US 90835**

(43) Date of publication of application:
**13.05.81 Bulletin 81/19**

(45) Publication of the grant of the patent:
**16.05.84 Bulletin 84/20**

(84) Designated Contracting States:
**DE GB NL**

(56) References cited:
**DE-A-2 845 418**
**DE-B-2 436 431**

(73) Proprietor: **XEROX CORPORATION**
**Xerox Square - 020**
**Rochester New York 14644 (US)**

(72) Inventor: **Hordon, Monroe J.**
**4 Sturbridge Lane**
**Pittsford New York (US)**
Inventor: **Gerace, Robert E.**
**34 Duncott Road**
**Fairport New York (US)**

(74) Representative: **Goode, Ian Roy et al**
**European Patent Attorney c/o Rank Xerox**
**Limited Patent Department 338 Euston Road**
**London NW1 3BH (GB)**

EP 0 028 514 B1

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

# Description

This invention relates to a process of vapor depositing a substantially uniform thin film of photoconductive material on a substrate body. The process comprises establishing an evacuated atmosphere about the substrate body and vaporising a photoconductive material contained within one or more crucibles.

The concept of xerography was originally described by Carlson in U.S. Patent No. 2,297,691 and is further amplified and described by many related patents in the field. The discovery of the photoconductive insulating properties of highly purified vitreous selenium has resulted in this material becoming a standard in reuseable commercial xerography. The outstanding advantages of vitreous selenium are its capability of holding and retaining an electrostatic charge for long periods of time when not exposed to light, and its relative sensitivity to light as compared to many other photoconductive materials. In addition, vitreous selenium exhibits excellent physical strength and stability to be reused or cycled thousands of times.

Vitreous selenium, however, does suffer from one serious disadvantage in that it becomes unstable at temperatures slightly above about 37.8°C and begins to crystallize and become conductive in the dark rendering it unsuitable for use in xerography. U.S. Patent Nos. 2,803,542 and 2,822,300 to Ullrich and Mayer et al., respectively, teach that the incorporation of elemental arsenic with selenium not only increases the spectral response of the selenium but in addition greatly increases the resistance of selenium to crystallization at elevated temperatures. In addition to alloying with arsenic, the addition of a halogen such as iodine or chlorine to arsenic-selenium alloys has been found to improve electrical characteristics such as sensitivity and spectral response. This contribution to the art is set forth in U.S. Patent No. 3,312,548 to Staughan.

The arsenic-selenium alloys described in the above patents, are normally prepared by mixing a master alloy having the appropriate proportion of arsenic and selenium and placing the material in a closed container capable of being evacuated. The evaporation is carried out under vacuum conditions by heating a crucible containing the alloy mixture and allowing vapors of the arsenic-selenium alloy to condense and form a vitreous layer on a substrate normally supported above the crucible containing the alloy.

U.S. Patent 3,911,162 to Erhart et al. discloses a method of vapor depositing a uniform film of photoconductive material on a substrate which comprises positioning a plurality of substrate bodies on a plurality of elongated horizontal extending cylindrical mandrels, rotating each of said mandrels about an associated longitudinal axis thereof while simultaneously transporting the mandrels in an annular path about a horizontal axis. Vapor deposition is carried out under vacuum using a photoconductive material, such as an arsenic-selenium alloy, which is positioned in a planar array of crucibles which is located within the annular path of travel of the mandrels.

Employing the evaporation methods and equipment disclosed in U.S. Patent 3,911,162 with selenium alloys containing up to about 0.5% by weight of arsenic fractionate, there is produced a progressive enrichment of arsenic content in the melt remainder. For the usual conditions in which a fixed charge of alloy is completely exhausted from the crucible, the photoreceptor also progressively enriches in arsenic level with the major portion of the arsenic content being concentrated in the final layers of the deposit, corresponding to the arsenic composition of the terminal melt volume. Generally, top surface arsenic contents of less than about 1% by weight or greater than about 5% by weight are considered undesirable. For many photoreceptors, including the Xerox 9200 and 3100 type photoreceptors, the preferred mean top surface arsenic content is about 2.5% by weight. Low top surface arsenic values may lead to photoreceptor failure through surface crystallization while high top surface arsenic levels can impair electrical properties such as residual voltage.

The present invention is intended to provide a process of vapor depositing a photoconductive material, and in particular for preparing arsenic-selenium photoreceptors, which is devoid of the above-noted disadvantages.

The process of the invention is characterised by controlling the evaporation rate of the photoconductive material in accordance with a desired program by means of an evaporation rate sensing system to monitor both evaporation rate of the photoconductive material and crucible temperature, said sensing system including a cascade dual-loop feedback control system continuously blending the evaporation rate and the crucible temperature to produce an integrated feedback response to modify resistive power input to said crucibles.

The invention has the advantage that it provides a process of preparing arsenic-selenium photoreceptors wherein the top surface arsenic content is controlled so that it is above the level which will lead to failure through surface crystallization, but is below the level at which electrical properties of the photoreceptor are impaired.

A cascaded crucible thermal heating control system was developed employing dual crucible temperature and arsenic-selenium alloy evaporation rate sensors to process crucible power input. The dual sensor inputs are continuously blended in the control system to produce an integrated feedback response covering the entire arsenic-selenium alloy coating cycle.

In the pre-evaporation and post-evaporation stages of the coating cycle when evaporation is negligible, crucible power input control is chiefly effected by the crucible temperature feedback loop. During the evaporation stage of the coating cycle, crucible power input is chiefly effected by the evaporation rate feedback loop.

Arsenic fractionation in arsenic-selenium photoreceptor films is controlled by controlling the average rate of alloy evaporation in the coating process. For evaporation rate sensing during the evaporation sequence, monitoring the time depletion of alloy weight in the crucible array was selected as the preferred sensing technique. However, it is apparent to those skilled in the art that alternative evaporation rate sensing methods including quartz crystal deposition, and electron impact emission spectroscopy, are included in the scope of the control system design.

In the preferred embodiment of the control system, evaporation rate is monitored by measuring the time rate of arsenic-selenium alloy weight depletion in the crucible array using a strain gauge load cell assembly. The configuration comprises a sensitive load measuring platform supporting the entire crucible array and underframe. The load platform design adopted comprises four series-connected load cells positioned at the corners of the rectangular crucible array, although other load platform designs could be employed.

In the load cell design, it is desired that the sensitivity to weight change be not less than 0.25% of the total arsenic-selenium alloy weight charged into the crucible array to distinguish a change in evaporation rate of 0.1 micron/minute.

To control the evaporation rate profile, the desired time rate of alloy weight loss is programmed into a Data Trak controller and coupled to the crucible thermal power input. In this mode, the secondary crucible temperature feedback signal is used to modulate the primary crucible weight loss signal so as to limit power excursions and reduce oscillation of the evaporation rate.

Although it can be shown that crucible temperature and evaporation rate are generally related for selenium alloys by an expression of the form:

$$\log E = A - B/T$$

where E is the evaporation rate (grams/cm²-sec) or (microns/min), T is the crucible temperature (° Kelvin), and A and B are suitable constants, practical control of the evaporation rate cannot be maintained solely by crucible temperature control due to changes in crucible resistivity and heat transmission with aging and due to variability in alloy behavior.

With the dual feedback control system, a variety of coating programs can be devised by establishing crucible weight loss profiles and corresponding crucible temperature limits to maintain fixed evaporation rate profiles in repeated coater cycling. To achieve correspondence, complementary weight loss and temperature control patterns are entered into tandem digital data/time programmer units with a common, locked time base. Crucible power input is adjusted against the control programs by cascading the input signal through a series of process controllers.

With the cascade evaporation rate control system installed in a Xerox 9200 photoreceptor vacuum coating unit using an alloy comprising selenium and 0.36 weight percent arsenic, rate variation is limited to ±0.1 microns/minute during the major portion of the coating sequence. The mean top surface arsenic level is found to vary with the evaporation rate, decreasing with increase in fixed rate value. Specifically, for the 9200 case, limiting the maximum evaporation rate below about 1.5 microns/minute will insure top surface arsenic values in the preferred range and minimize the occurrence of top surface arsenic levels below 1% arsenic. Tests of the procedures outlined above for 9200 photoreceptor have resulted in improved top surface arsenic control with standard deviations of 0.5% arsenic. Additionally, no individual photoreceptors have been measured with top surface arsenic values of less than 1% arsenic or greater than 5% arsenic. Top surface arsenic measurements were obtained by electron microprobe absorption technique with 6 KV radiation corresponding to a top surface mean penetration depth of about 0.3 microns. Further, all coating trials were carried out in a planetary vacuum coater.

In one way of carrying out the process of the invention, using a planetary vacuum coater, the substrate bodies, in the form of cylindrical sleeves, are supported on a plurality of horizontally extending support mandrels of elongated cylindrical form. The mandrels are rotated about their axes and are simultaneously transported in an annular path about a horizontal axis. The chamber containing the mandrels is evacuated, and photoconductive material is vaporised in the chamber. The photoconductive material is positioned in a planar array of crucibles located within the annular path of travel of the mandrels, with at least one additional crucible being positioned in an outrigger configuration at each corner of the planar array, the crucible array extending substantially coextensively along the entire length of the plurality of substrate bodies.

Although reduction in top surface arsenic variability is demonstrated for the 9200 photoreceptor, top surface arsenic may be likewise controlled in any arsenic-selenium photoreceptor in a similar manner.

## Claims

1. A process of vapor depositing a substantially uniform thin film of photoconductive material on a substrate body which comprises establishing an evacuated atmosphere about the substrate body and vaporising a photoconductive material contained within one or more crucibles, characterised by controlling the evaporation rate of the photoconductive material in accordance with a desired program by means of an evaporation rate sensing system to monitor both evaporation rate of the photoconductive material and crucible temperature, said sensing system including a cascade dual-loop feedback control system continuously blending the evaporation rate and crucible temperature to produce an integrated feedback response to modify resistive power input to said crucibles.

2. The process of claim 1 wherein said photoconductive material comprises an alloy of selenium and arsenic.

3. The process of claim 2 wherein the evaporation rate of said alloy is controlled so that there is between about 1% and 5% by weight of arsenic in the top surface of the resulting photoreceptor.

4. The process of claim 2 wherein the evaporation rate of said alloy is controlled so that there is about 2.5% by weight of arsenic in the top surface of the resulting photoreceptor.

5. The process of claim 1 wherein the evaporation rate of the photoconductive material is monitored using a strain load cell assembly wherein the crucible or crucibles are supported on a series-connected strain gauge load cell platform.

6. The process of claim 1 comprising:

positioning a plurality of substrate bodies on a plurality of elongated, horizontally extending cylindrical support mandrels;

rotating each of said mandrels about an associated longitudinal axis thereof and simultaneously transporting said plurality of mandrels in an annular path about a horizontal axis;

establishing the evacuated atmosphere about said mandrels; and

vaporizing photoconductive material, which is positioned in a planar array of crucibles located within the annular path of travel of said mandrels, with at least one additional crucible being positioned in an outrigger configuration at each corner of the planar array, said crucible array extending substantially coextensively along the entire length of the plurality of substrate bodies.

**Patentansprüche**

1. Verfahren zur Dampfabscheidung eines im wesentlichen gleichmäßigen dünnen Films eines photoleitfähigen Materials auf eine Trägerkörper, welches Verfahren die Herstellung einer luftentleerten Atmosphäre um den Trägerkörper und das Verdampfen eines in einem oder mehreren Schmelztiegeln enthaltenen photoleitfähigen Materials umfaßt, gekennzeichnet durch Regelung der Verdampfungsgeschwindigkeit des photoleitfähigen Materials in Übereinstimmung mit einem gewünschten Programm mittels eines Abfühlsystems für die Verdampfungsgeschwindigkeit zum Messen der Verdampfungsgeschwindigkeit des photoleitfähigen Materials und der Schmelztiegeltemperatur, wobei das genannte Abfühlsystem ein Kaskaden-Doppelschleifen-Rückkoppelungssystem aufweist, das die Verdampfungsgeschwindigkeit und die Schmelztiegeltemperatur kontinuierlich mischt, um eine integrierte Rückkoppelungsreponse zur Änderung der Widerstands-Leistungsaufnahme der genannten Schmelztiegel zu erzeugen.

2. Verfahren nach Anspruch 1, in welchem das genannte photoleitfähige Material eine Legierung aus Selen und Arsen umfaßt.

3. Verfahren nach Anspruch 2, in welchem die Verdampfungsgeschwindigkeit, der genannten Legierung derart geregelt wird, daß zwischen etwa 1 Gewichts-% und 5 Gewichts-%en Arsen sich in der Oberfläche des sich ergebenden Photorezeptors befinden.

4. Verfahren nach Anspruch 2, in welchem die Verdampfungsgeschwindigkeit der genannten Legierung derart geregelt wird, daß etwa 2,5 Gewichts-%e Arsen sich in der Oberfläche des sich ergebenden Photorezeptors befinden.

5. Verfahren nach Anspruch 1, in welchem die Verdampfungsgeschwindigkeit des photoleitfähigen Materials unter Verwendung einer Dehnungsmeßdosenanordnung gemessen wird, in welcher der Schmelztiegel oder die Schmelztiegel auf einer in Reihe geschalteten Dehnungsmeßdosen-Plattform abgestützt sind.

6. Verfahren nach Anspruch 1, mit den Verfahrensschritten

des Anordnens einer Mehrzahl von Trägerkörpern auf einer Mehrzahl langgestreckter, horizontal verlaufender, zylindrischer Aufnahmedorne,

des Drehens jedes der genannten Dorne um dessen zugeordnete Längsachse und des gleichzeitigen Förderns der genannten Mehrzahl der Dorne in einer ringförmigen Bahn um eine horizontale Achse,

des Herstellens der luftentleerten Atmosphäre um die genannten Dorne, und

des Verdampfens des photoleitfähigen Materials, das sich in einer ebenen Anordnung von Schmelztiegeln befindet, die innerhalb der ringförmigen Bewegungsbahn der genannten Dorne angeordnet ist, wobei wenigstens ein zusätzlicher Schmelztiegel in einer Ausleger-Konfiguration an jeder Ecke der ebenen Anordnung positioniert ist, welche Schmelztiegel-Anordnung sich im wesentlichen in gemeinsamer Ausdehnung entlang der Gesamtlänge der Mehrzahl der Trägerkörper erstreckt.

**Revendications**

1. Procédé de dépôt, à partir de phase vapeur, d'une couche mince de substance photoconductrice pratiquement uniforme sur un substrat, comprenant l'établissement d'une atmosphère sous pression réduite autour du substrat et la vaporisation d'une substance photoconductrice contenue dans un ou plusieurs creusets, caractérisé par le fait que l'on règle la vitesse de vaporisation de la substance photoconductrice conformément à un programme voulu, au moyen d'un dispositif de détection de la vitesse de vaporisation, pour contrôler aussi bien la vitesse de vaporisation de la substance photoconductrice que la température du ou des creuset (s), ce dispositif de détection comprenant un circuit de réglage à rétroaction à double boucle en cascade effectuant un mélange continu des informations correspondant à la vitesse de vaporisation et à la température du creuset pour engendrer une réponse rétroactive intégrée afin de modifier l'alimentation électrique des résistances de chauffage desdits creusets.

2. Procédé selon la revendication 1, selon lequel ladite substance photoconductrice comprend un alliage de sélénium et arsenic.

3. Procédé selon la revendication 2, selon lequel on règle la vitesse de vaporisation dudit alliage de façon qu'il y ait entre 1% et 5%, environ, en poids, d'arsenic sur la surface supérieure du photorécepteur finalement obtenu.

4. Procédé selon la revendication 2, selon lequel on règle la vitesse de vaporisation dudit alliage de façon qu'il y ait environ 2,5% en poids d'arsenic sur la surface supérieure du photorécepteur finalement obtenu.

5. Procédé selon la revendication 1, selon lequel on contrôle la vitesse de vaporisation de la substance photoconductrice au moyen d'un dispositif à jauge de contrainte, le ou les creuset (s) étant supportés par une plate-forme de jauges de contrainte connectées en série.

6. Procédé selon la revendication 1, comprenant:

la mise en position d'une pluralité de corps jouant le rôle de substrats sur une pluralité de mandrins cylindriques allongés, s'étendant horizontalement, servant de support;

la mise en rotation de chacun de ces mandrins autour d'un axe longitudinal qui lui est associé et le transport simultané de ladite pluralité. de mandrins selon un chemin annulaire autour d'un axe horizontal;

l'établissement de l'atmosphère sous pression réduite autour desdits mandrins; et la vaporisation de la substance photoconductrice, qui est placée dans un arrangement plan de creusets disposés à l'intérieur du chemin annulaire des mandrins, au moins un creuset supplémentaire étant placé en position de porte-en-dehors à chaque coin de l'arrangement plan de creusets, ce dernier s'étendant pratiquement sur toute la longueur de la pluralité de substrats.